# EUROPEAN PATENT SPECIFICATION

(11) **EP 3 479 416 B1**
(45) Date of publication and mention of the grant of the patent: **24.03.2021**
(21) Application number: 17821030.8
(22) Date of filing: 26.06.2017
(51) Int. Cl.: H01L 31/0224, H01L 31/0392, H01L 31/0368, H01L 31/0216, H01L 31/18

(54) **METALLIZATION STRUCTURES FOR SOLAR CELLS**
METALLISIERUNGSSTRUKTUREN FÜR SOLARZELLEN
STRUCTURES DE MÉTALLISATION DESTINÉES À DES CELLULES SOLAIRES

(30) Priority: 01.07.2016 US 201615201361
(43) Date of publication of application: 08.05.2019
(73) Proprietor: SunPower Corporation, San Jose CA 95134 (US); Total Marketing Services, 92800 Puteaux (FR)
(72) Inventor: MOORS, Matthieu, 1440 Braine-le-Chateau (BE); KIM, Taeseok, San Jose, CA 95134 (US); HARDER, Nils-Peter, San Jose, CA 95130 (US)
(74) Representative: Grünecker Patent- und Rechtsanwälte PartG mbB
(86) International application number: PCT/US2017/039334
(87) International publication number: WO 2018/005386

(56) References cited:
- WO-A1-2016/133695
- US-A1- 2015 090 329
- US-A1- 2015 179 866
- US-A1- 2015 318 420
- US-A1- 2016 079 450
- US-A1- 2016 181 447
- US-B1- 7 339 110

## Description

### BACKGROUND

Photovoltaic (PV) cells, commonly known as solar cells, are devices for conversion of solar radiation into electrical energy. Generally, solar radiation impinging on the surface of, and entering into, the substrate of a solar cell creates electron and hole pairs in the bulk of the substrate. The electron and hole pairs migrate to p-doped and n-doped regions in the substrate, thereby creating a voltage differential between the doped regions. The doped regions are connected to the conductive regions on the solar cell to direct an electrical current from the cell to an external circuit. When PV cells are combined in an array such as a PV module, the electrical energy collected from all of the PV cells can be combined in series and parallel arrangements to provide power with a certain voltage and current.

US 2015/0318420 A1 relates to a solar cell including a conductive contact disposed on a semiconductor region, wherein the conductive contact includes a conductive foil bonded to the semiconductor region. Techniques for increasing the efficiency of solar cells, or techniques for increasing the efficiency in the manufacture of solar cells, are generally desirable. The present invention provides a solar cell according to claim 1 and a method of fabricating a solar cell according to claim 18 and allows for increased solar cell manufacturing efficiency by providing novel processes for fabricating solar cell structures.

### BRIEF DESCRIPTION OF THE DRAWINGS

Figure 1 illustrates a flow chart representation of an example method for fabricating a solar cell, according to some embodiments.
Figure 2 illustrates a stage in solar cell fabrication following formation of a protective layer formed above a substrate of a solar cell, according to some embodiments.
Figure 3 illustrates the structure of Figure 2 following patterning the protective layer, according to some embodiments.
Figure 4 illustrates the structure of Figure 3 following forming a first metal layer over the substrate, according to some embodiments.
Figure 5 illustrates the structure of Figure 4 following forming a second metal layer over the first metal layer, according to some embodiments.
Figure 6 illustrates bonding the second metal layer to the first metal layer of Figure 5, according to some embodiments.
Figure 7 illustrates a solar cell formed from the methods of Figure 1-6, according to some embodiments.
Figure 8 illustrates a top view of a portion of an example configuration for the solar cell of Figure 7, according to some embodiments.
Figure 9 illustrates a top view of a portion of another example configuration for the solar cell of Figure 7, according to some embodiments.
Figure 10 illustrates a top view of a portion of still another example configuration for the solar cell of Figure 7, according to some embodiments.
Figure 11 illustrates a top view of a portion of yet another example configuration for the solar cell of Figure 7, according to some embodiments.
Figure 12 illustrates example cell efficiency data, according to some embodiments.

### DETAILED DESCRIPTION

The following detailed description is merely illustrative in nature and is not intended to limit the embodiments of the subject matter of the application or uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions and/or context for terms found in this disclosure (including the appended claims):

"Comprising." This term is open-ended. As used in the appended claims, this term does not foreclose additional structure or steps.

"Configured To." Various units or components may be described or claimed as "configured to" perform a task or tasks. In such contexts, "configured to" is used to connote structure by indicating that the units/components include structure that performs those task or tasks during operation. As such, the unit/component can be said to be configured to perform the task even when the specified unit/component is not currently operational (e.g., is not on/active).

"First," "Second," etc. As used herein, these terms are used as labels for nouns that they precede, and do not imply any type of ordering (e.g., spatial, temporal, logical, etc.). For example, reference to a "first" bond region does not necessarily imply that this bond region is the first bond region in a sequence, instead the term "first" is used to differentiate this bond region from another bond region (e.g., a "second" bond region). In an embodiment, a bond region can be a region which couples one layer to another layer. In an example, a bond region can couple a first metal layer to a second metal layer. In one example, a bond region can be a metal weld disposed between the first metal layer and second metal layer. In some examples, the bond region is a thermal bond region (e.g., a bond region formed from a thermal compression process).

"Based On." As used herein, this term is used to describe one or more factors that affect a determination. This term does not foreclose additional factors that may affect a determination. That is, a determination may be solely based on those factors or based, at least in part, on those factors. Consider the phrase "determine A based on B." While B may be a factor that affects the determination of A, such a phrase does not foreclose the determination of A from also being based on C. In other instances, A may be determined based solely on B.

"Coupled" - The following description refers to elements or nodes or features being "coupled" together. As used herein, unless expressly stated otherwise, "coupled" means that one element/node/feature is directly or indirectly joined to (or directly or indirectly communicates with) another element/node/feature, and not necessarily mechanically.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, and/or effect which might otherwise occur. Accordingly, when a component, element, or feature is referred to as inhibiting a result or state, it need not completely prevent or eliminate the result or state.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

In the following description, numerous specific details are set forth, such as specific operations, in order to provide a thorough understanding of embodiments of the present disclosure. It will be apparent to one skilled in the art that embodiments of the present disclosure may be practiced without these specific details. In other instances, well-known techniques are not described in detail in order to not unnecessarily obscure embodiments of the present disclosure.

Approaches for metallization of solar cells and the resulting solar cells are described herein. In the following description, numerous specific details are set forth, such as specific solar cell structures and process flow operations, in order to provide a thorough understanding of embodiments of the present disclosure. It will be apparent to one skilled in the art that embodiments of the present disclosure may be practiced without these specific details. In other instances, well-known fabrication techniques, such as lithography and patterning techniques, are not described in detail in order to not unnecessarily obscure embodiments of the present disclosure. Furthermore, it is to be understood that the various embodiments shown in the figures are illustrative representations and are not necessarily drawn to scale.

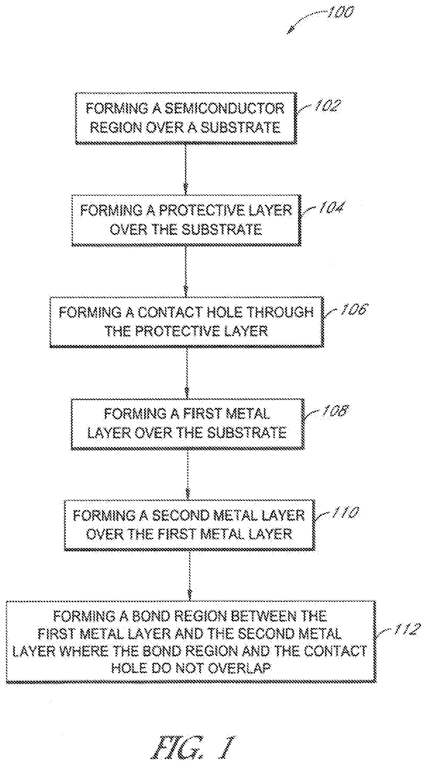

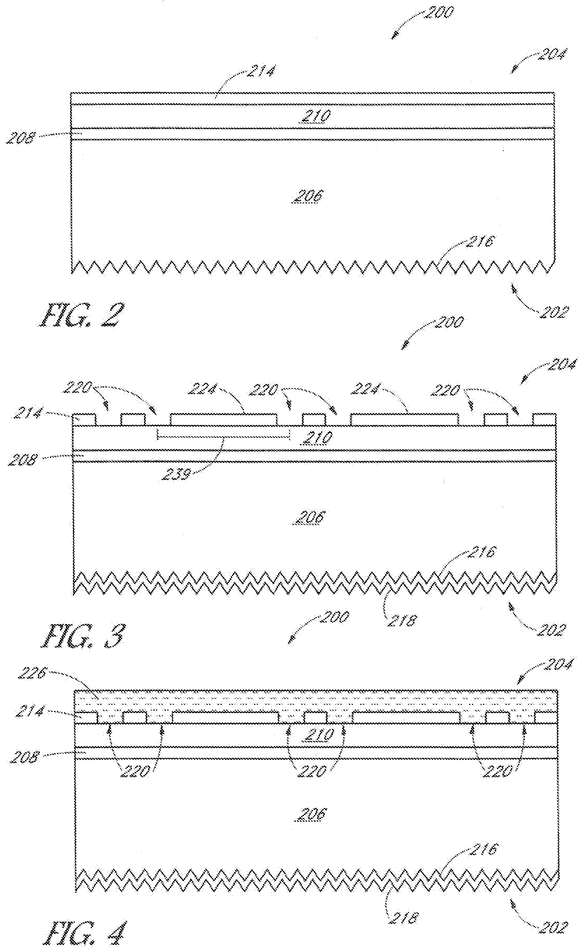

Disclosed herein are methods of fabricating solar cells. In an exemplary process flow, Figure 1 illustrates a flowchart 100 listing operations in a method of fabricating a solar cell corresponding to Figures 2-8, according to some embodiments. In various embodiments, the method of Figure 1 can include additional (or fewer) blocks than illustrated. For example, in some embodiments, a heating step can be performed after forming a metal seed layer over the substrate, at block 110.

Embodiments described herein include fabrication of a solar cell 200, according to some embodiments. Referring to Figure 2 and corresponding operation 102 of flowchart 100, a semiconductor region 210 can be formed in or above a substrate 206. In an example, as shown in Figure 1, the substrate 206 has disposed there above a semiconductor region 210. In an embodiment, the semiconductor region 210 is a n-type doped semiconductor region. In one embodiment, the semiconductor region 210 is a p-type doped semiconductor region. In some embodiments, the semiconductor region 210 can be an amorphous silicon region. In one embodiment, the region 210 can be a metal oxide having a high or low work function (e.g., work required to remove an electron from a material). Some examples, the semiconductor region 210 can be formed in the substrate 206. In an example, the semiconductor region 210 is an emitter region. In one embodiment, the semiconductor region 210 can be a polysilicon region. In an example, the semiconductor region 210 can be a heavily doped polysilicon region. In an embodiment, the semiconductor region 210 can be a doped n-type or a doped p-type polysilicon region. In an embodiment, a thin dielectric layer 208 can be disposed between the semiconductor region 210 and the substrate 206. In an embodiment, where the semiconductor region 210 is formed in the substrate 206, the thin dielectric layer 208 need not be formed. Although a cross-sectional view of a single semiconductor region is shown, a plurality of semiconductor regions can be used. In an example, a first semiconductor region and/or a second semiconductor region can be formed over the substrate 206. In one example, the first semiconductor region and/or a second semiconductor region can be n-type and/or p-type emitter regions. In an embodiment, the n-type and p-type emitter regions are formed in the substrate itself, in which case the dielectric layer 208 would not be included. In an embodiment, the first semiconductor region and/or a second semiconductor region can be doped n-type and/or doped p-type polysilicon regions. In some embodiments, a trench region can be formed which can separate the first and second semiconductor region. In an example, a trench region can be disposed between the first and second semiconductor regions. In an embodiment, the substrate 206 includes a light-receiving surface 216 on a front side 202 opposite a back side 204 of the solar cell 200. Although, as shown, the semiconductor region 210 is formed on a back side 204 of the solar cell 200, in some embodiments, the semiconductor region 210 can be formed on a front side 202 of the solar cell 200.

In an embodiment, the substrate 206 is a monocrystalline silicon substrate, such as a bulk single crystalline n-type doped silicon substrate. It is to be appreciated, however, that substrate 206 may be a layer, such as a multi-crystalline silicon layer, disposed on a global solar cell substrate. In an embodiment, the thin dielectric layer 208 is a tunneling silicon oxide layer having a thickness of approximately 2 nanometers or less. In one such embodiment, the term "tunneling dielectric layer" refers to a very thin dielectric layer, through which electrical conduction can be achieved. The conduction may be due to quantum tunneling and/or the presence of small regions of direct physical connection through thin spots in the dielectric layer 208. In one embodiment, the tunneling dielectric layer is or includes a thin silicon oxide layer. In an embodiment, the dielectric layer 208 includes silicon oxide (e.g., SiO₂), aluminum oxide (e.g., Al₂O₃), or an intrinsic amorphous silicon layer.

In an embodiment, the semiconductor region 210 is a polycrystalline silicon formed by, e.g., using a plasma-enhanced chemical vapor deposition (PECVD) process. In one such embodiment, the semiconductor region 210 is doped with an n-type impurity, such as phosphorus (e.g., n-type semiconductor region). In an embodiment, the semiconductor region 210 is doped with a p-type impurity, such as boron (e.g., p-type semiconductor region). As discussed above, although a cross-sectional view of a single semiconductor region is shown, a plurality of semiconductor regions can be used (e.g., n-type and p-type semiconductor regions).

In an embodiment, the light receiving surface 216, is a texturized light-receiving surface, as is depicted in Figure 2. In one embodiment, a hydroxide-based wet etchant is employed to texturize the light receiving surface 216 of the substrate 206. In an embodiment, a texturized surface may be one which has a regular or an irregular shaped surface for scattering incoming light, decreasing the amount of light reflected off of the light receiving surfaces 216 of the solar cell 200. In some embodiments, the light receiving surface 216 need not be texturized.

Referring again to Figure 2 and corresponding operation 104 of flowchart 100, a protective layer 214 can be formed over the substrate 206, according to some embodiments. In an embodiment, the protective layer 214 can also be referred to as an insulating layer. In one embodiment, the protective layer 214 includes a passivation layer and/or a back anti-reflective coating (BARC). In an example, the protective layer 214 includes silicon nitride, silicon dioxide and/or amorphous silicon. In an embodiment, the protective layer 214 can be a dielectric layer (e.g., include one or more dielectrics). In one embodiment, the protective layer 214 can include polyimide.

Referring to Figure 3 and corresponding operation 106 of flowchart 100, contact holes 220 can be formed through the protective layer 214, according to some embodiments. In an embodiment, the contact holes 220 are formed to accommodate direct contact of a first metal layer to the second semiconductor region 210 (e.g., as discussed in Figure 4 below). In an embodiment, the contact holes 220 are formed by a patterning process. In an example, a laser ablation, lithography and/or etching process can be performed to form the contact holes 220. In one embodiment, the contact holes 220 can have a diameter of approximately less than or equal to 50 microns. In an example, a contact holes having a 30 micron diameter can be formed. In one embodiment, protective layer 214 can include locations 224 without contact holes formed. In an example, these locations 224 can be referred to as contact hole free zones 224. In an embodiment, a distance, or gap 239, between contact holes 220 having a contact hole free zone 224 located between is approximately less than or equal to 0.50 millimeters.

Additional embodiments can include forming of a passivation and/or front anti-reflective coating (ARC) layer 218 on a light-receiving surface 216 at the front side 202 of the substrate 206. In an example, the front anti-reflective coating (ARC) layer 218 can include silicon nitride. It is to be appreciated that the timing of the formation of the protective layer 214 and/or ARC layer 218 may also vary. For example, subsequent to forming the protective layer 214 on the back side 204 (e.g., a BARC layer) of the substrate 206, the ARC layer 218 can be formed on the front side 202. In one embodiment, the protective layer 214 can be formed subsequently after the ARC layer 218. In some embodiments, both the protective layer 214 and the ARC layer 218 can be formed in a single process (e.g., the same process step).

Referring to Figure 4 and corresponding operation 108 of flowchart 100, a first metal layer 226 is formed over the substrate 206 (which may be referred to as a metal seed layer and/or a M1 layer, for the solar cell 200), according to some embodiments. In an embodiment, the first metal layer 226 can be formed as an uninterrupted layer over the substrate 206. In an embodiment, portions of the first metal layer 216 can contact the semiconductor region 210 at the contact holes 220 of the protective layer 214. In one example, the first metal layer 226 can be formed using a blanket deposition process. In one example, a sputtering process can be used to deposit the first metal layer 226. In an embodiment, the first metal layer 216 can formed using a patterning process (e.g., a printing process). In an example, a screen printing process can be performed to form the first metal layer. In one example, a patterned metal seed layer can be formed. In some embodiments, the first metal layer 226 can include a metal paste (e.g., an aluminum paste). In an embodiment, the first metal layer 226 can include one or more metals and/or metal alloys. In an example, the first metal layer 226 can include aluminum, titanium tungsten, tungsten, and/or copper, among other metals. In an embodiment, the first metal layer 226 can be formed significantly thin. In an example, the first metal layer 226 can be formed having a thickness of approximately less than or equal to 400 nanometers.

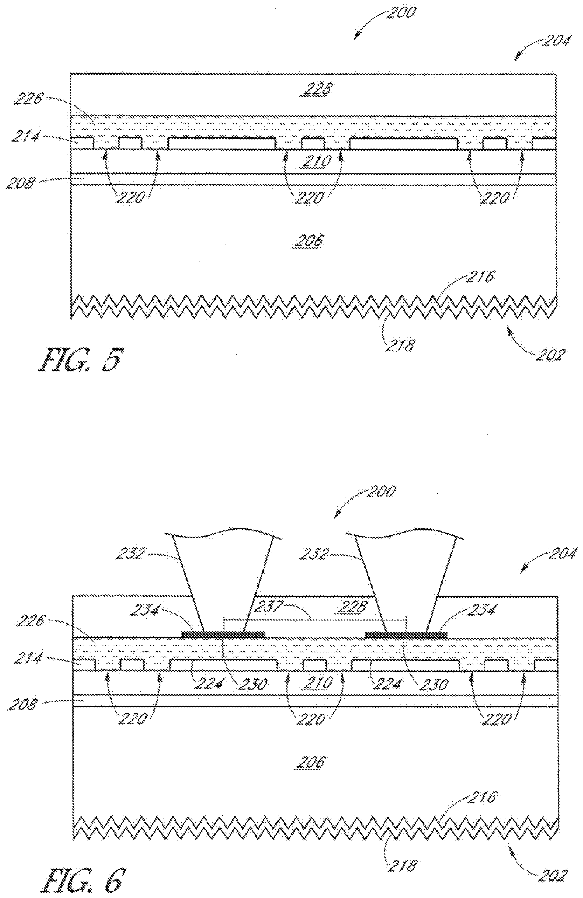

Referring to Figure 5 and corresponding operation 110 of flowchart 100, a second metal layer 228 can be formed over the first metal layer 226. In an embodiment, the second metal layer 228 is a metal foil, according to some embodiments. In an example, a metal foil 228 can be placed over the first metal layer 226. In an embodiment, the metal foil 228 is an aluminum foil. In an embodiment, the metal foil 228 can be pre-patterned and/or placed over the semiconductor region 210. In an example, a patterned metal foil can be placed over the semiconductor regions 210. In one example, the patterned metal foil can follow a pattern in alignment with the semiconductor region 210.

In an embodiment, metal foil 228 is an aluminum (Al) foil having a thickness approximately in a range of 5-100 microns and, in one example, having a thickness of approximately less than 50 microns. In one embodiment, the Al foil is an aluminum alloy foil including aluminum and second element such as, but not limited to, copper, manganese, silicon, magnesium, zinc, tin, lithium, or combinations thereof. In one embodiment, the Al foil is a temper grade foil such as, but not limited to, F-grade (as fabricated), O-grade (full soft), H-grade (strain hardened) or T-grade (heat treated).

Referring to Figure 6 and corresponding operation 112 of flowchart 300, bond regions 234 can be formed between the first metal layer 226 and the second metal layer 228, according to some embodiments. In an embodiment, a bonding process can be used to form the bond regions 234. In an example, the bonding process can include performing a laser welding, thermal compression process or an ultrasonic bonding process. In an example, a laser welding process can be performed to form a bond region between a metal foil 228 and a metal seed layer 226. In one embodiment, the bond region 234 is formed by directing a laser 232 over the second metal layer 228. In one example, the bond region 234 is a metal weld 234 formed from a laser welding process. In an example, the metal weld can be a line weld and/or a spot weld. As used herein, metal welds can be used interchangeably with bond regions. In an embodiment, a pitch 237 between bond regions 234 (e.g., distance from the center of one bond region to another bond region) is approximately less than or equal to 5 millimeters. In an example, the pitch 237 can be 1.00 millimeters. In one embodiment, the bond region 234 can have a diameter of approximately less than or equal to 100 microns. In an example, a metal weld 234 having an 80 micron diameter can be formed. In an embodiment, the bond region 234 is a melted region of the second metal layer 228. In one example, the bond region 234 can be a melted region of a metal foil.

Forming a bond region 234 in direct overlap with contact holes can be detrimental to the operation of the solar cell 200. In an example, laser welding above a contact hole 220 can cause intermixing and/or diffusion of contaminants which can degrade the performance of a solar cell by introducing recombination sites in a semiconductor region of the solar cell. In one example, these recombination sites can be in-diffused contaminants or metal. In an example, these recombination sites can also be crystal defects arising from imperfect re-crystallization of the semiconductor upon cooling of the intermixed phase. In an example, the recombination sites can also be caused by altering (upon intermixing and/or recrystallization), for example, redistribution of dopants and/or introducing doping via metal incorporation, such as in a p-type aluminum doping of silicon. In one example, another mechanism of degrading the solar cell performance upon intermixing and/or in-diffusion of metal and/or contaminants is contamination of a tunnel oxide (e.g. dielectric layer 208). Thus, in an embodiment, the bond regions 234 are formed at locations 230 above contact hole free zones 224 of the protective layer 214 (e.g., at locations that do not directly overlap with at least one contact hole 220).

In an embodiment, a laser can be scanned at different scanning speeds over a metal layer to allow the formation of metal welds which do not overlap with contact holes of the protective layer. Thus, forming the bond regions 234 can include locally scanning a laser over metal layer as also described in U.S. Patent App. No. 15/201,349, published as US 2018/0006171 A1.

In an embodiment, the protective layer 214 can prevent and/or inhibit damage to the underlying substrate 206 during the bonding process. In one embodiment, the protective layer 214 prevents and/or inhibits radiative damage to the semiconductor region 210 from a laser welding process during the formation of a bond region 234. In an example, to minimize solar cell manufacturing cost and material usage, the first metal layer 226 can be formed significantly thin (e.g., approximately less than equal to 400 nanometers). In the same example where the first metal layer 226 is formed significantly thin, the protective layer 214 can prevent and/or inhibit damage to the semiconductor region 210 due to radiative and/or thermal damage from a laser welding process. In one embodiment, the protective layer 214 prevents and/or inhibits thermal damage to the semiconductor region 210 from a thermal compression process during the formation of a bond region 234. In an example, a thermal compression process can be performed to form a bond region 234 between a metal foil 228 and a metal seed layer 226. In one example, the bond region 234 is a thermal bond region.

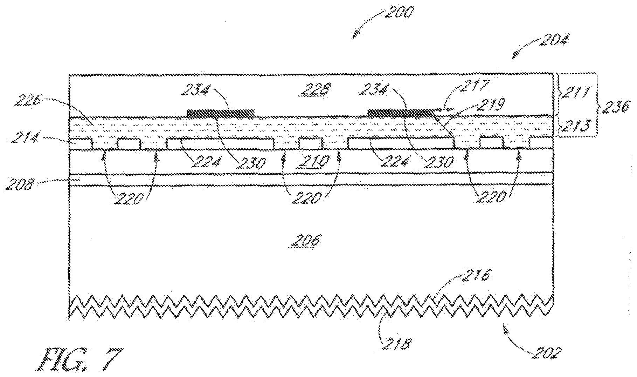

Figure 7 illustrates a solar cell formed from the methods of Figures 1-6, according to some embodiments. In an embodiment, the solar cell 200 includes a substrate 206. In an embodiment, the solar cell 200 has a front side 202 and a back side 204, opposite the front side 202. In one embodiment, the solar cell 200 includes a semiconductor region 210 disposed in (not shown) or above (as shown) the substrate 206. As discussed above, in an example, the substrate 206 can be a monocrystalline silicon substrate, such as a bulk single crystalline n-type doped silicon substrate.

In an embodiment, a protective layer 214 is disposed over the semiconductor region 210. In an embodiment, the protective layer 214 can also be referred to as an insulating layer. In one embodiment, the protective layer 214 includes a passivation layer and/or a back anti-reflective coating (BARC). In an example, the protective layer 214 includes silicon nitride, silicon oxide and/or amorphous silicon. In an embodiment, the protective layer 214 can be a dielectric layer (e.g., include one or more dielectrics). In one embodiment, the protective layer can include polyimide.

In an embodiment, the protective layer 214 includes contact holes and/or openings 220 formed through the protective layer 214. In one embodiment, the contact holes 220 can have a diameter of approximately less than or equal to 50 microns. In an example, a contact holes having a 30 micron diameter can be formed. In one embodiment, protective layer 214 can include locations 224 without contact holes formed. In an example, these locations 224 can be referred to as contact hole free zones 224.

In one embodiment, a conductive contact 236 is disposed over the protective layer 214 and are electrically connected to the semiconductor region 210 through the contact holes 220. Although only a single conductive contact 236 and/or semiconductor region 210 is shown, more than one conductive contact 236 and/or semiconductor region 210, e.g., two or more conductive contacts 236 and/or semiconductor regions 210 can be present. In an embodiment, the conductive contact 236 includes a second metal layer 228 228 disposed over a first metal layer 226. In an embodiment, the first metal layer 226 can be formed significantly thin. In an example, the first metal layer 226 can be formed having a thickness 213 of approximately less than or equal to 400 nanometers. In an embodiment, the second metal layer 228 can be formed significantly thick. In an example, the second metal layer 228 can be formed having a thickness 211 approximately in a range of 25-75 microns. In an example, the conductive contact 236 includes a metal foil portion 228 disposed over a metal seed layer 226. In an embodiment, the metal seed layer 226 is disposed over the substrate 206, where portions of the metal seed layer 226 are in contact with the semiconductor region 210 at the contact holes 220. In an embodiment, contact holes 220 allow for electrical conduction between the metal seed layer 226 and the semiconductor region 210. Although, as shown, the conductive contact 236 and/or semiconductor region 210 is formed on a back side 204 of the solar cell 200, in some embodiments the conductive contact 236 and/or semiconductor region 210 can be formed on a front side 202 of the solar cell 200.

In an embodiment, bond regions 234 electrically connect the metal foil 228 to the metal seed layer 226. In one embodiment, the bond regions 234 can have a diameter of approximately less than or equal to 100 microns. In an example, a bond regions 234 having an 80 micron diameter can be formed. In some embodiments, a lateral distance from an edge 217 of a bond regions 234 to an edge of a contact hole can be approximately in a range of 10-100 microns. In one embodiment, a direct distance 219 from an edge 217 of a bond region 234 to an edge of a contact hole can be approximately in a range of 50-150 microns. In an embodiment, the bond region 234 is a metal weld formed from a laser welding process. In one embodiment, the bond region 234 is a thermal bond region 234 (e.g., a bond region formed from a thermal compression process). Forming a bond region 234 in direct overlap with contact holes 220 can be detrimental to the operation of a solar cell. In an example, laser welding above a contact hole 220 can cause deep intermixing and/or diffusion of contaminants, as discussed above, from the metal seed layer 226 into the semiconductor region 210. Thus, in an embodiment, the bond regions 234 are disposed over the metal seed layer 226 at locations 230 above contact hole free zones 224 of the protective layer 214. In an embodiment, the bond regions 234 provide structural support between the metal foil 228 and metal seed layer 226.

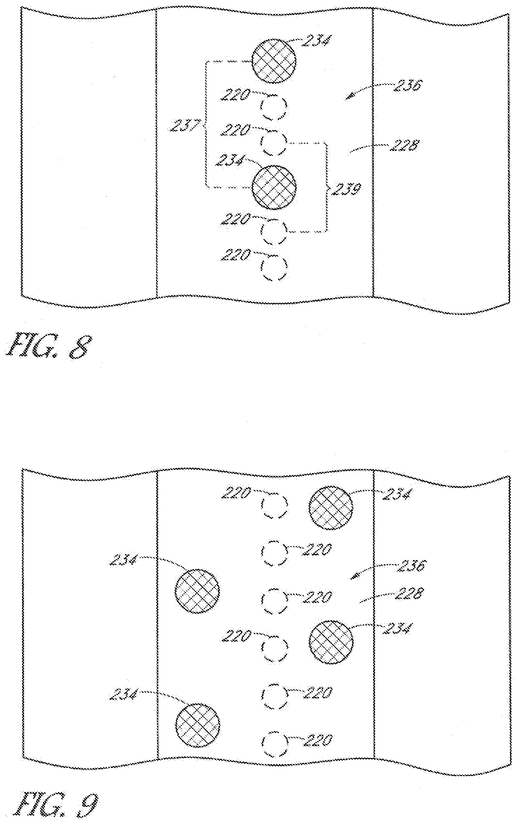

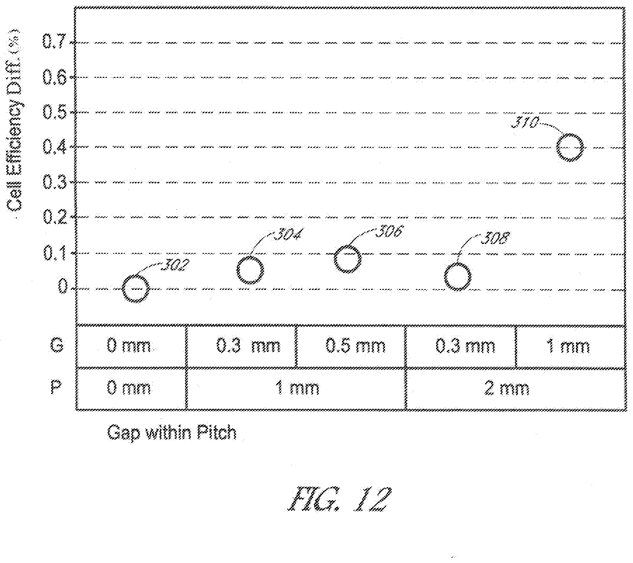

With reference to Figure 8, there is shown a top view of a portion of an example configuration for the solar cell of Figure 7, according to some embodiments. In an embodiment, bond regions 234 can be formed in linear alignment with contact holes 220. In an embodiment, a pitch 239 between bond regions 234 (e.g., distance from the center of one bond region to another bond region) is approximately less than or equal to 5 millimeters. In an example, the pitch 237 can be 1.00 millimeters. In one embodiment, the bond region 234 can have a diameter of approximately less than or equal to 100 microns. In an example, a bond region 234 having an 80 micron diameter can be formed. In one embodiment, the contact holes 220 can have a diameter of less than or equal to 50 microns. In an example, a contact holes having a 30 micron diameter can be formed. In an embodiment, a distance or gap 239 (e.g., distance from the center of one contact hole to another contact hole), between contact holes 220, having a bond region 234 formed between, is approximately less than or equal to 0.50 millimeters. Varying the gap 239 and pitch 237 to provide an optimal pathway for charger carriers to travel from the semiconductor region 210 (e.g., 210 of Figure 7) and through the conductive contact 236 can allow for improved solar cell efficiency, an example of which is shown in Figure 12 below.

Figure 9 illustrates a top view of a portion of another example configuration for the solar cell of Figure 7, according to some embodiments. As shown, in an embodiment, the contact holes 220 can be aligned linearly along a center of a conductive contact 236. In an embodiment, bond regions 234 can be located adjacent to the contact holes 220 and are located along edges of the conductive contact 236 as shown.

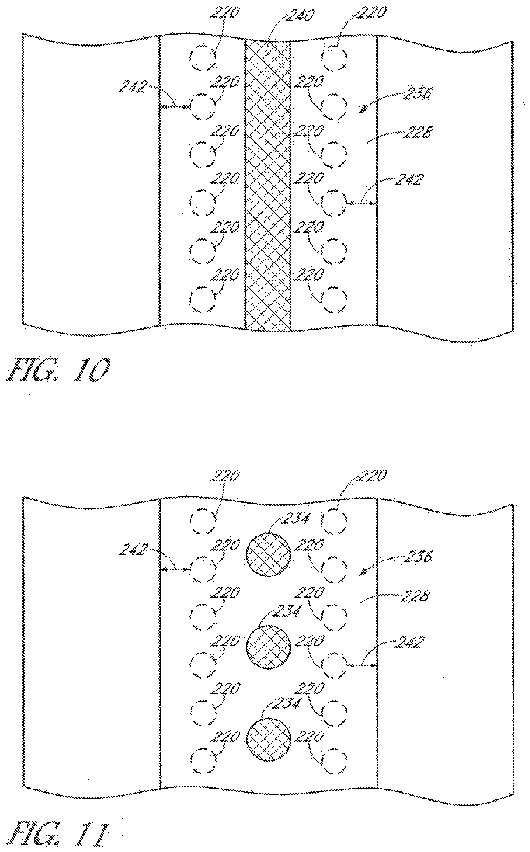

With reference to Figure 10, there is shown a top view of a portion of still another example configuration for the solar cell of Figure 7, according to some embodiments. As shown, a continuous bond region 240 can be formed and aligned linearly along a center of a conductive contact 236. In an example, the continuous bond region 240 can be referred to as a line weld. As shown, in an embodiment, the contact holes 220 can be aligned linearly and/or adjacent the continuous bond region 240. In an embodiment, the contact holes 220 can have distance 242 of approximately less than or equal to 500 nanometers from an edge of a contact hole 220 to an edge of the conductive contact 236.

Figure 11 illustrates a top view of a portion of a portion of yet another example configuration for the solar cell of Figure 7, according to some embodiments. Figure 11 shows a similar configuration to Figure 10 but instead of having a continuous weld 240 or line weld, as in Figure 10, spot welds 234 can instead be formed. As shown, a bond regions 234 can be formed and aligned linearly along a center of a conductive contact 236. As shown, in an embodiment, the contact holes 220 can be aligned linearly and/or adjacent to bond regions 234. In an embodiment, the contact holes 220 can have distance 242 of less than or equal to 500 nanometers from an edge of a contact hole to an edge of the conductive contact 236.

With reference to Figure 12 example solar cell efficiency data is shown, according to some embodiments. Referring to Figure 8 and the data shown in Figure 12, **G** represents a gap between contact holes 239 and **P** represents a pitch between bond regions 237, emphasis added. The gap **G** is a distance from the center of one contact hole to another contact hole (e.g., as shown in 239 Figure 8). The pitch **P** is a distance from the center of one bond region to another bond region (e.g., as shown in 237 Figure 8). Points 302-310 illustrate representative data calculations gathered for the absolute value of the difference in solar cell efficiency from a control solar cell, 302, and solar cells 304-310 with varied gap **G** and pitch **P.** An optimal configuration can be a configuration which minimizes efficiency loss, e.g., approximately less than or equal to 0.1% in reference to the control solar cell 302. Points 304, 306 and 308 represent example configurations of **G** and **P** which show minimized efficiency loss. 310 represents an example where the absolute value of the solar cell efficiency difference varies significantly from the control 302. It can be possible that the **G** and **P** configuration for 310 provides for a longer pathway for charge carriers in comparison to points 304, 306 and 308 and thus reduced solar cell efficiency.

## Claims

1. A solar cell comprising:
a protective layer (214) disposed over a substrate (206), wherein the protective layer (214) comprises contact holes (220);
a first metal layer (226) disposed over the protective layer (214), wherein the first metal layer (226) is electrically connected to the substrate (206) through the contact holes (220);
a second metal layer (228) disposed over the first metal layer (226); and
bond regions (234) disposed between the first metal layer (226) and the second metal layer (228) and coupling the first metal layer to the second metal layer, **characterised in that** entirely the bond regions (234) are located above regions of the protective
layer (214) that do not overlap with at least one contact hole (220);
wherein the contact holes (220) are aligned linearly and/or adjacent to the bond regions (234).

2. The solar cell of claim 1, further comprising a semiconductor region (210) disposed between the protective layer (214) and the substrate (206).

3. The solar cell of claim 2, wherein the semiconductor region (210) is a polysilicon region.

4. The solar cell of claim 2, further comprising a dielectric layer (208) formed between the semiconductor region (210) and the substrate (206).

5. The solar cell of claim 4, wherein the dielectric layer (208) is a tunneling silicon oxide.

6. The solar cell of claim 1, wherein a pitch distance between the bond region and the other bond region is approximately less than or equal to 5 millimeters.

7. The solar cell of claim 1, wherein a gap distance (239, G) between the contact hole (220) and the other contact hole (220) is approximately less than or equal to 0.5 millimeters.

8. The solar cell of claim 1, wherein the bond region (234) is a metal weld or a thermal bond region.

9. The solar cell of claim 1, wherein the protective layer (214) is an insulating layer, dielectric layer, passivation layer or an anti-reflective coating.

10. The solar cell of claim 1, wherein the protective layer (214) comprises silicon nitride, silicon dioxide, aluminum oxide, titanium oxide, aluminum nitride, or polyimide.

11. The solar cell of claim 1, wherein the first metal layer (226) comprises a thickness of approximately less than or equal to 400 nanometers.

12. The solar cell of any one of claims 1 to 11, further comprising a single semiconductor region (210) between the protective layer (214) and the substrate (206), wherein the contact holes (220) are disposed over the semiconductor region (210).

13. The solar cell of claim 12, wherein a conductive contact (236) is disposed over the protective layer (214) and electrically connected to the semiconductor region (210) through the contact holes (220), the conductive contact (236) includes the first metal layer (226), the second metal layer (228) and the bond regions (234).

14. The solar cell of any one of claims 1 to 13, wherein the bond regions (234) are formed in linear arrangement with the contact holes (220).

15. The solar cell of claim 13, wherein the bond regions (234) are located adjacent to the contact holes (220) and are located along edges of the conductive contact (236).

16. The solar cell of claim 13, wherein the bond regions (234) form a continuous bond region (240),
the contact holes (220) are aligned linearly and/or adjacent to the continuous bond region (240), and have a predetermined distance from an edge of one of the contact holes (220) to an edge of the conductive contact (236).

17. The solar cell of claim 13, wherein the bond regions (234) are formed and aligned linearly along a center of the conductive contact (236).

18. A method of fabricating a solar cell, the method comprising:
forming a protective layer (214) over a substrate (206);
forming contact holes (220) in the protective layer (214);
forming a first metal layer (226) over the protective layer (214), wherein the first metal layer (226) is electrically connected to the substrate (206) through the contact holes (220);
placing a metal foil (228) over the first metal layer (226); and
forming bond regions (234) between the first metal layer (226) and the metal foil (228), the bond regions coupling the first metal layer to the second metal layer,
wherein the protective layer (214) inhibits damage to the substrate (206) during the
formation of the bond regions, **characterised in that** the bond regions are entirely located above regions of the protective layer (214)
that do not overlap with at least one contact hole (220);
wherein the contact holes (220) are aligned linearly and/or adjacent to the bond regions (234).

19. The method of claim 18, wherein forming the bond regions (234) comprises performing a laser welding or a thermo compression process.

## Patentansprüche

1. Solarzelle, umfassend:
eine Schutzschicht (214), die über einem Substrat (206) angeordnet ist, wobei die Schutzschicht (214) Kontaktlöcher (220) umfasst;
eine erste Metallschicht (226), die über der Schutzschicht (214) angeordnet ist, wobei die erste Metallschicht (226) durch die Kontaktlöcher (220) elektrisch mit dem Substrat (206) verbunden ist;
eine zweite Metallschicht (228), die über der ersten Metallschicht (226) angeordnet ist; und
Verbindungsregionen (234), die zwischen der ersten Metallschicht (226) und der zweiten Metallschicht (228) angeordnet sind und die erste Metallschicht an die zweite Metallschicht koppeln, **dadurch gekennzeichnet, dass** sich die Verbindungsregionen (234) vollständig über Regionen der Schutzschicht (214) befinden, die sich nicht mit mindestens einem Kontaktloch (220) überlappen;
wobei die Kontaktlöcher (220) linear zu den Verbindungsregionen (234) ausgerichtet und/oder diesen benachbart sind.

2. Solarzelle nach Anspruch 1, ferner umfassend eine Halbleiterregion (210), die zwischen der Schutzschicht (214) und dem Substrat (206) angeordnet ist.

3. Solarzelle nach Anspruch 2, wobei die erste Halbleiterregion (210) eine Polysiliziumregion ist.

4. Solarzelle nach Anspruch 2, ferner umfassend eine dielektrische Schicht (208), die zwischen der Halbleiterregion (210) und dem Substrat (206) gebildet ist.

5. Solarzelle nach Anspruch 4, wobei die dielektrische Schicht (208) ein Siliziumtunneloxid ist.

6. Solarzelle nach Anspruch 1, wobei ein Teilungsabstand zwischen der Verbindungsregion und der anderen Verbindungsregion ungefähr kleiner oder gleich 5 Millimetern ist.

7. Solarzelle nach Anspruch 1, wobei ein Spaltabstand (239, G) zwischen dem Kontaktloch (220) und dem anderen Kontaktloch (220) ungefähr kleiner oder gleich 0,5 Millimetern ist.

8. Solarzelle nach Anspruch 1, wobei die Verbindungsregion (234) eine Metallschweißung oder eine thermische Verbindungsregion ist.

9. Solarzelle nach Anspruch 1, wobei die Schutzschicht (214) eine Isolierschicht, eine dielektrische Schicht, eine Passivierungsschicht oder eine Antireflexionsbeschichtung ist.

10. Solarzelle nach Anspruch 1, wobei die Schutzschicht (214) Siliziumnitrid, Siliziumdioxid, Aluminiumoxid, Titanoxid, Aluminiumnitrid oder Polyimid umfasst.

11. Solarzelle nach Anspruch 1, wobei die erste Metallschicht (226) eine Dicke von ungefähr weniger als oder gleich 400 Nanometern aufweist.

12. Solarzelle nach einem der Ansprüche 1 bis 11, ferner umfassend eine einzelne Halbleiterregion (210) zwischen der Schutzschicht (214) und dem Substrat (206), wobei die Kontaktlöcher (220) über der Halbleiterregion (210) angeordnet sind.

13. Solarzelle nach Anspruch 12, wobei ein leitfähiger Kontakt (236) über der Schutzschicht (214) angeordnet und über die Kontaktlöcher (220) elektrisch mit der Halbleiterregion (210) verbunden ist, wobei der leitfähige Kontakt (236) die erste Metallschicht (226), die zweite Metallschicht (228) und die Verbindungsregionen (234) beinhaltet.

14. Solarzelle nach einem der Ansprüche 1 bis 13, wobei die Verbindungsregionen (234) in linearer Anordnung mit den Kontaktlöchern (220) ausgebildet sind.

15. Solarzelle nach Anspruch 13, wobei sich die Verbindungsregionen (234) neben den Kontaktlöchern (220) befinden und sich entlang der Kanten des leitfähigen Kontakts (236) befinden.

16. Solarzelle nach Anspruch 13, wobei die Verbindungsregionen (234) eine durchgehende Verbindungsregion (240) bilden,
wobei die Kontaktlöcher (220) linear zur durchgehenden Verbindungsregion (240) ausgerichtet und/oder dieser benachbart sind und einen vorgegebenen Abstand von einer Kante eines der Kontaktlöcher (220) zu einer Kante des leitfähigen Kontakts (236) aufweisen.

17. Solarzelle nach Anspruch 13, wobei die Verbindungsregionen (234) linear entlang einer Mitte des leitfähigen Kontakts (236) gebildet und ausgerichtet sind.

18. Verfahren zum Herstellen einer Solarzelle, wobei das Verfahren umfasst:
Bilden einer Schutzschicht (214) über einem Substrat (206);
Bilden von Kontaktlöchern (220) in der Schutzschicht (214);
Bilden einer ersten Metallschicht (226) über der Schutzschicht (214), wobei die erste Metallschicht (226) durch die Kontaktlöcher (220) elektrisch mit dem Substrat (206) verbunden ist;
Platzieren einer Metallfolie (228) über der ersten Metallschicht (226); und
Bilden von Verbindungsregionen (234) zwischen der ersten Metallschicht (226) und der Metallfolie (228), wobei die Verbindungsregionen die erste Metallschicht an die zweite Metallschicht koppeln,
wobei die Schutzschicht (214) eine Schädigung des Substrats (206) während der Bildung der Verbindungsregionen verhindert, **dadurch gekennzeichnet, dass** sich die Verbindungsregionen vollständig über Regionen der Schutzschicht (214) befinden, die sich nicht mit mindestens einem Kontaktloch (220) überlappen;
wobei die Kontaktlöcher (220) linear zu den Verbindungsregionen (234) ausgerichtet und/oder diesen benachbart sind.

19. Verfahren nach Anspruch 18, wobei das Bilden der Verbindungsregionen (234) das Durchführen eines Laserschweißens oder eines Thermokompressionsprozesses umfasst.

## Revendications

1. Cellule solaire comprenant :
une couche protectrice (214) disposée sur un substrat (206), dans laquelle la couche protectrice (214) comprend des trous de contact (220) ;
une première couche métallique (226) disposée sur la couche protectrice (214), dans laquelle la première couche métallique (226) est électriquement connectée au substrat (206) à travers les trous de contact (220) ;
une seconde couche métallique (228) disposée sur la première couche métallique (226) ; et
des régions de liaison (234) disposées entre la première couche métallique (226) et la seconde couche métallique (228) et couplant la première couche métallique à la seconde couche métallique, **caractérisée en ce que** les régions de liaison (234) sont entièrement situées au-dessus de régions de la couche protectrice (214) qui ne chevauchent pas au moins un trou de contact (220) ;
dans laquelle les trous de contact (220) sont alignés linéairement et/ou adjacents aux régions de liaison (234).

2. Cellule solaire selon la revendication 1, comprenant en outre une région semi-conductrice (210) disposée entre une la couche protectrice (214) et le substrat (206).

3. Cellule solaire selon la revendication 2, dans laquelle la région semi-conductrice (210) est une région en polysilicium.

4. Cellule solaire selon la revendication 2, comprenant en outre une couche diélectrique (208) formée entre la région semi-conductrice (210) et le substrat (206).

5. Cellule solaire selon la revendication 4, dans laquelle la couche diélectrique (208) est de l'oxyde de silicium à effet tunnel.

6. Cellule solaire selon la revendication 1, dans laquelle une distance de pas entre la région de liaison et l'autre région de liaison est approximativement inférieure ou égale à 5 millimètres.

7. Cellule solaire selon la revendication 1, dans laquelle une distance d'écartement (239, G) entre le trou de contact (220) et l'autre trou de contact (220) est approximativement inférieure ou égale à 0,5 millimètre.

8. Cellule solaire selon la revendication 1, dans laquelle la région de liaison (234) est une soudure métallique ou une région de liaison thermique.

9. Cellule solaire selon la revendication 1, dans laquelle la couche protectrice (214) est une couche isolante, une couche diélectrique, une couche de passivation ou un revêtement antireflet.

10. Cellule solaire selon la revendication 1, dans laquelle la couche protectrice (214) comprend du nitrure de silicium, du dioxyde de silicium, de l'oxyde d'aluminium, de l'oxyde de titane, du nitrure d'aluminium ou du polyimide.

11. Cellule solaire selon la revendication 1, dans laquelle la première couche métallique (226) comprend une épaisseur approximativement inférieure ou égale à 400 nanomètres.

12. Cellule solaire selon l'une quelconque des revendications 1 à 11, comprenant en outre une seule région semi-conductrice (210) entre la couche protectrice (214) et le substrat (206), dans laquelle les trous de contact (220) sont disposés sur la région semi-conductrice (210).

13. Cellule solaire selon la revendication 12, dans laquelle un contact conducteur (236) est disposé sur la couche protectrice (214) et connecté électriquement à la région semi-conductrice (210) à travers les trous de contact (220), le contact conducteur (236) comprenant la première couche métallique (226), la seconde couche métallique (228) et les régions de liaison (234).

14. Cellule solaire selon l'une quelconque des revendications 1 à 13, dans laquelle les régions de liaison (234) sont formées en agencement linéaire avec les trous de contact (220).

15. Cellule solaire selon la revendication 13, dans laquelle les régions de liaison (234) sont situées à côté des trous de contact (220) et sont situées le long de bords du contact conducteur (236).

16. Cellule solaire selon la revendication 13, dans laquelle les régions de liaison (234) forment une région de liaison continue (240),
les trous de contact (220) sont alignés linéairement et/ou adjacents à la région de liaison continue (240) et ont une distance prédéterminée d'un bord de l'un des trous de contact (220) à un bord du contact conducteur (236).

17. Cellule solaire selon la revendication 13, dans laquelle les régions de liaison (234) sont formées et alignées linéairement le long d'un centre du contact conducteur (236).

18. Procédé de fabrication d'une cellule solaire, le procédé comprenant :
la formation d'une couche protectrice (214) sur un substrat (206) ;
la formation de trous de contact (220) dans la couche protectrice (214) ;
la formation d'une première couche métallique (226) sur la couche protectrice (214),
dans laquelle la première couche métallique (226) est électriquement connectée au substrat (206) à travers les trous de contact (220) ;
le placement d'une feuille métallique (228) sur la première couche métallique (226) ; et
la formation de régions de liaison (234) entre la première couche métallique (226) et la feuille métallique (228), les régions de liaison couplant la première couche métallique à la seconde couche métallique,
dans laquelle la couche protectrice (214) empêche l'endommagement du substrat (206) pendant la formation des régions de liaison, **caractérisé en ce que** les régions de liaison sont entièrement situées au-dessus de régions de la couche protectrice (214) qui ne chevauchent pas au moins un trou de contact (220) ;
dans laquelle les trous de contact (220) sont alignés linéairement et/ou adjacents aux régions de liaison (234).

19. Procédé selon la revendication 18, dans lequel la formation des régions de liaison (234) comprend l'exécution d'un soudage au laser ou d'un processus de thermocompression.
